# EUROPEAN PATENT SPECIFICATION

(11) **EP 2 971 221 B1**
(45) Date of publication and mention of the grant of the patent: **14.08.2019**
(21) Application number: 13878420.2
(22) Date of filing: 16.12.2013
(51) Int. Cl.: C23C 8/16, C23C 8/80, C23C 14/22, C23C 16/40, C23C 16/455, C23C 16/46, C23C 28/04

(54) **PREHEAT CHAMBER OXIDATION PROCESS**
VORHEIZKAMMER-OXIDATIONSVERFAHREN
PROCÉDÉ D'OXYDATION DE CHAMBRE DE PRÉCHAUFFAGE

(30) Priority: 14.03.2013 US 201361781484 P
(43) Date of publication of application: 20.01.2016
(73) Proprietor: United Technologies Corporation, Farmington, CT 06032 (US)
(72) Inventor: RIDGEWAY, Neil B., South Windsor, Connecticut 06074 (US)
(74) Representative: Dehns
(86) International application number: PCT/US2013/075271
(87) International publication number: WO 2014/143259

(56) References cited:
- EP-A1- 0 926 257
- EP-A1- 2 236 642
- EP-A1- 2 365 104
- EP-A1- 2 365 107
- JP-A- 2002 339 052
- US-A1- 2002 152 961
- US-A1- 2007 231 589
- US-A1- 2009 169 752
- US-A1- 2011 217 560
- NIJDAM T J ET AL: "Development of a Pre-Oxidation Treatment to Improve the Adhesion between Thermal Barrier Coatings and NiCoCrAlY Bond Coatings", OXIDATION OF METALS, KLUWER ACADEMIC PUBLISHERS-PLENUM PUBLISHERS, NE, vol. 66, no. 5-6, 28 November 2006 (2006-11-28), pages 269-294, XP019453210, ISSN: 1573-4889, DOI: 10.1007/S11085-006-9036-8

## Description

### BACKGROUND

The present disclosure is related to a process for coating a part such as a turbine engine component.

Prior to electron beam physical deposition (EB-PVD) of ceramic thermal barrier coatings of zirconia or zirconia containing materials, substrates forming the parts are bond coated. Often, the bond coat is formed from a MCrAlY material. After the bond coat is formed, the substrate with the bond coat is conditioned and preheated in a vacuum.

During the preheating treatment in the preheat chamber, and depending upon the environment, the substrate can develop a surface oxide. Typically, the preheat chamber maintains a hard vacuum to prevent oxidation during preheat. Instead of maintaining a protective atmosphere during preheat, the atmosphere can be controlled to develop specific oxides. This oxide is referred to as a thermally grown oxide (TGO). In the final product, this TGO resides at the interface between the bond coat and the ceramic thermal barrier or outer coating. The type, thickness, and quantity of the thermally grown oxide layer will influence the durability of the subsequently deposited thermal barrier coating. It can be said that the thermally grown oxide provides the critical link between the bond coat and the ceramic thermal barrier coating.

Alpha alumina is a desirable protective scale for most superalloys used for the substrates and for MCrAlY coatings. Alpha alumina forms at high temperatures as a well bonded scale which serves as a protective scale. Alpha alumina is a desirable phase of aluminum oxide for adhesion to the metallic substrate, along with cohesive strength. Additionally, ceramic coatings bond well to the thermally grown oxide on the bond coat. Complex oxides containing nickel, or cobalt, for example, create a TGO that can benefit the adhesion of ceramic coatings that are not compatible with alumina TGOs.

Metastable oxides can form at the metallic-ceramic interface of a thermal barrier coating system. Such oxides can adversely affect coating durability. Complex or mixed oxide thermally grown oxides are poorly bonded, low integrity oxides and their presence at the bond coat - thermal barrier coating interface may adversely affect top coat (thermal barrier coating) adhesion.

Specific TGO formation requires process control to ensure proper formation or each coating run (i.e., controlled time, temperature, pressure and environment). EP 2365107 teaches a coating process.

### SUMMARY

In accordance with the present disclosure, there is provided a process for coating a part as defined by claim 1.

The process comprises backfilling the preheat chamber with a protective atmosphere.

[DELETED]

[DELETED]

[DELETED]

[DELETED]

[DELETED]

[DELETED]

In an alternative embodiment, the process further comprises forming a coating over the thermally grown oxide layer.

[DELETED]

[DELETED]

[DELETED]

[DELETED]

[DELETED]

[DELETED]

[DELETED]

[DELETED]

[DELETED]

Other details of the preheat chamber oxidation process are set forth in the following detailed description and the accompanying drawings wherein like reference numerals depict like elements.

### BRIEF DESCRIPTION OF THE DRAWINGS

Fig. 1 is a schematic representation of a process for performing a coating process;
Fig. 2 is a schematic representation of a process for performing a coating process using a protective atmosphere in the preheat chamber;
Fig. 3 is an Ellingham Diagram showing a hierarchy of oxidizers;
Fig. 4 is an Ellingham Diagram for a typical preheat environment; and
Fig. 5 is an Ellingham Diagram for a preheat equilibrium environment containing carbon monoxide/carbon dioxide at preheat ramp up temperatures.

Sl unit conversions in the figures: (1°F - 32) × 5/9 = -17.22°C and 1 Torr = 133.322 Nm⁻².

### DETAILED DESCRIPTION

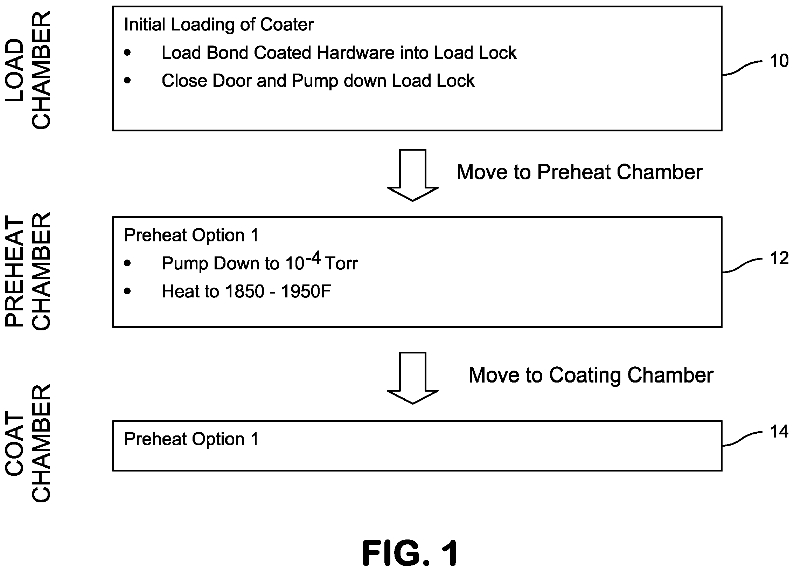

Referring now to the drawings, FIG. 1 illustrates a process for coating a part such as a turbine engine component. As shown in step 10, a load chamber is provided. Prior to being loaded into the load chamber, each part is provided with a bond coat such as a MCrAlY, aluminide, or platinum aluminide bond coat. One or more bond coated parts are placed into the load chamber. The door to the load chamber is closed and the load chamber is pumped down by a roughing pump to a desired pressure.

In step 12, the gate between the load chamber and a preheat chamber is opened. The bond coated parts are moved to a preheat chamber. In the preheat chamber, the atmosphere is pumped down so as to obtain a very low pressure on the order of 1.33 Nm⁻² (10⁻² Torr). Thereafter, the bond coated parts are heated to a temperature in the range of from 982°C to 1093°C (1800 to 2000 degrees Fahrenheit) for a desired period of time using one or more heating elements.

After the bond coated parts have been preheated, the gate between the preheat chamber and the coating chamber is opened. The parts are then moved from the preheat chamber to an electron beam physical vapor coating chamber as shown in step 14. In the coating chamber, the outer coating or the thermal barrier coating may be applied to the bond coated substrate using an EB-PVD deposition technique.

In the process shown in Fig. 1, the preheat operation offers radiant heating to parts in a low pressure environment. The atmospheric composition is approximately 80% nitrogen and 19% oxygen. During the heat up, there is enough oxygen available to promote oxidation. Being radiant heating, the heating is slow and the bond coated parts spend significant time in the 371°C to 982°C (700 to 1800 degree Fahrenheit) temperature range - a temperature range which is conducive to mixed oxides developing on the surface of the bond coat prior to the deposition of the outer or thermal barrier coating.

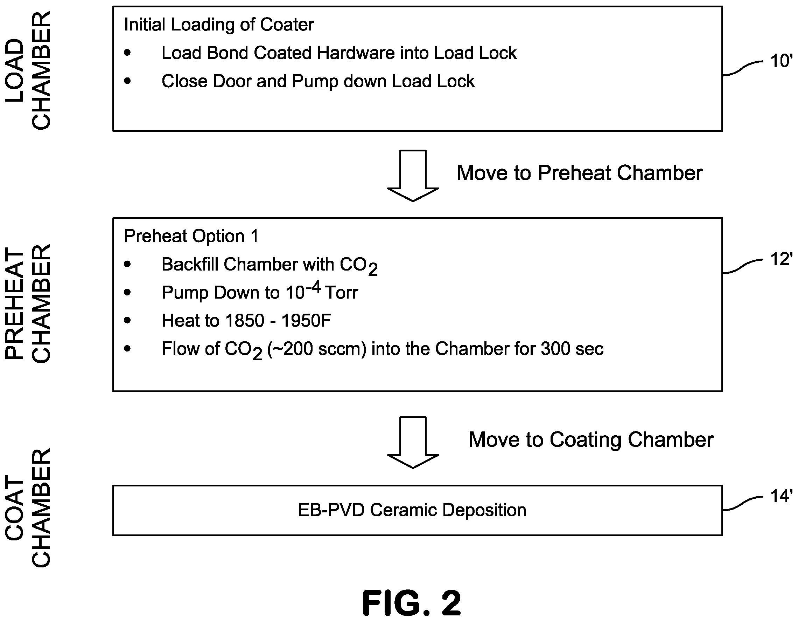

It has been found to be desirable to provide a protective atmosphere which avoids the development of such mixed oxides. A process for doing this is shown in Fig. 2. In particular, there is shown a coating process in which the preheat chamber is provided with a protective atmosphere.

In the process shown in Fig. 2, in step 10', the bond coated parts are placed into a load chamber and treated as before. Thereafter, in step 12', after the bond coated parts have been placed in the preheat chamber, the preheat chamber is backfilled with an oxidizer such as carbon dioxide, moist argon (dew point >-60 °C), or moist hydrogen (dew point >-60 °C). The chamber is then pumped down to a low pressure environment, e.g. a pressure in the range of from 1.33 Nm⁻² to 0.00133Nm⁻² (10⁻² Torr to 10⁻⁵ Torr). The bond coated parts are then heated to a temperature in the range of 982°C to 1093°C (1800 to 2000 degrees Fahrenheit) while in an atmosphere containing the protective gas. After reaching a temperature above 1000°C (1832 degrees Fahrenheit), a flow of the reactive gas at a flow rate in the range of 50-500 sccm is introduced into the preheat chamber until ready for ceramic deposition.

After the preheating treatment is completed, as shown in step 14", the preheated bond coated parts are moved to the coating chamber for deposition of an outer or thermal barrier coating formed from a suitable ceramic material such as zirconia or an yttria- or gadolinia-stabilized zirconia.

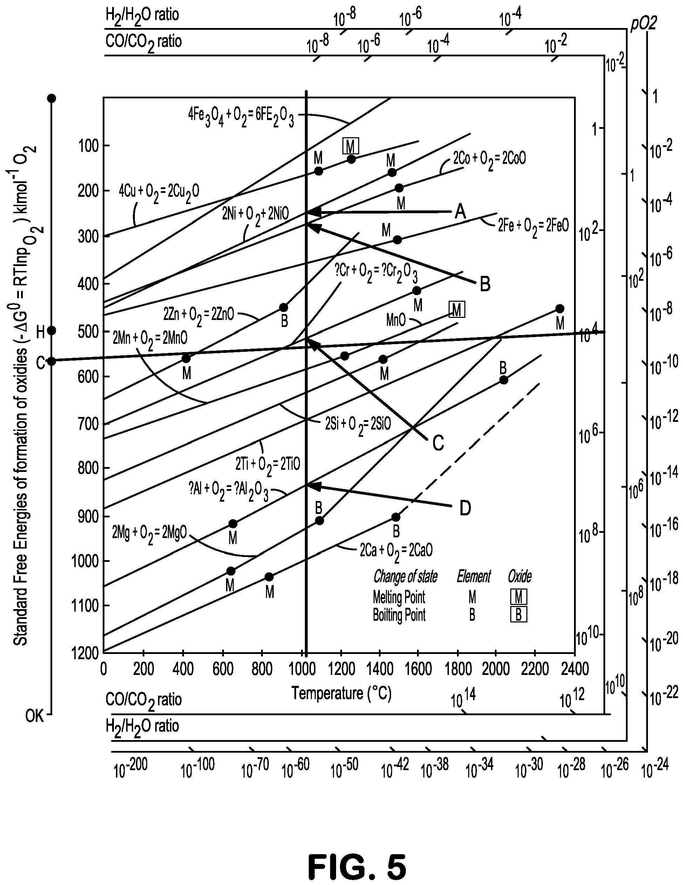

Carbon monoxide in the chamber may be the product of carbon dioxide reacting with carbon at high temperatures. During the preheat treatment described in connection with the process of FIG. 2, a carbon monoxide/carbon dioxide ratio atmosphere approaches equilibrium, consuming most of the carbon dioxide, as the carbon heating elements and carbon based susceptors react with the carbon dioxide. Even with the significant consumption of the carbon dioxide (or, the formation of carbon monoxide) during the preheat process, the equilibrium ratio between these two species is 10,000 (Figure 5) which is sufficient to promote only alumina formation and minimize the formation of metastable oxides of nickel, cobalt, chrome and aluminum during the preheat treatment at temperatures below 982°C (1800F). Carbon monoxide, metallurgically speaking, is both a carburizing and mild reducing agent. Depending upon time, temperature, and pressure, carbon monoxide can be used as a protective environment, inhibiting the formation of undesirable oxides. Carbon dioxide, metallurgically speaking, is both a decarburizing and oxidizing agent. Depending upon time, temperature, and pressure, carbon dioxide can be used to preferentially develop specific oxides.

In introducing the carbon dioxide into the preheat chamber during step 12', the flow rates should be maintained low so that even if the carbon dioxide reacts 100% with the heating elements in the preheat chamber, forming carbon monoxide, the loss would be negligibly small. Carburization conditions are maintained so that conditions not favoring carburization are maintained. For carbon monoxide to be carburizing, the partial pressure should be above 0.00133 Nm ⁻² (10⁻⁵ Torr).

To appreciate the benefits of a protective environment such as that offered by carbon dioxide, one can refer to its thermodynamic properties and the properties of the metallic constituents of a MCrAlY bond coat. In particular, one can appreciate that the relationship that carbon dioxide has with the development of nickel, chrome cobalt, and aluminum oxides. The following equation describes metal oxidation. The more negative the ΔG (free energy), the more favorable the reaction.

Metal + Oxygen → Metal Oxide, -ΔG (Energy of Formation)

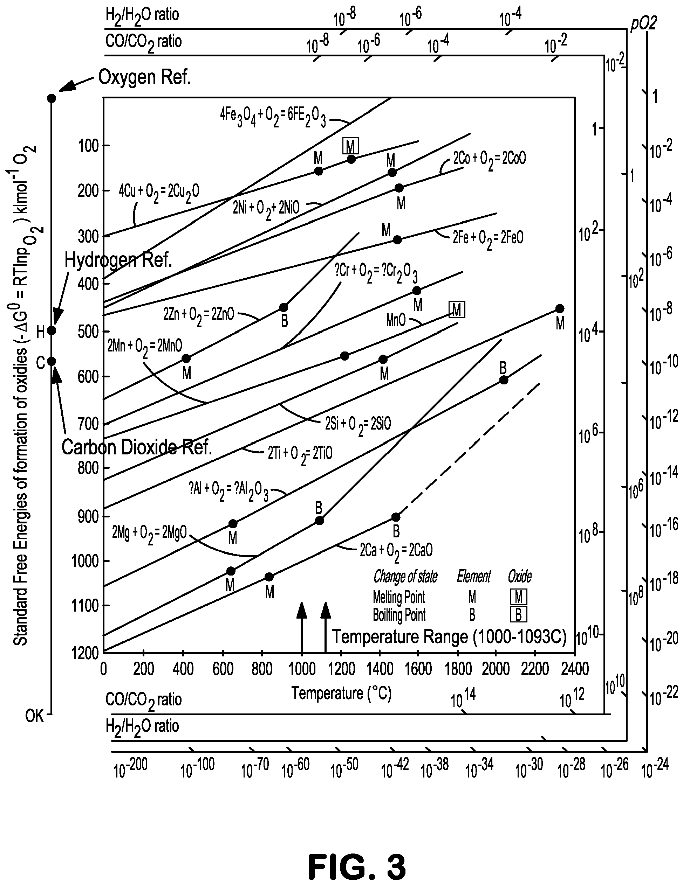

The Ellingham Diagram shown in Fig. 3 graphically summarizes the change in standard free energies associated with temperature and environments for the formation of various oxides. The Ellingham diagram is used to compare the equilibrium states of selected metal oxidation reaction. Or, in simple terms, whether or not the reaction is favorable. The Ellingham Diagram shows equilibrium relationships of various metal-metal oxide reactions through a range of temperatures in environments of oxygen, hydrogen and carbon dioxide. As can be seen from the diagram, carbon dioxide environments are lower than oxygen, yet sufficient to oxidize aluminum.

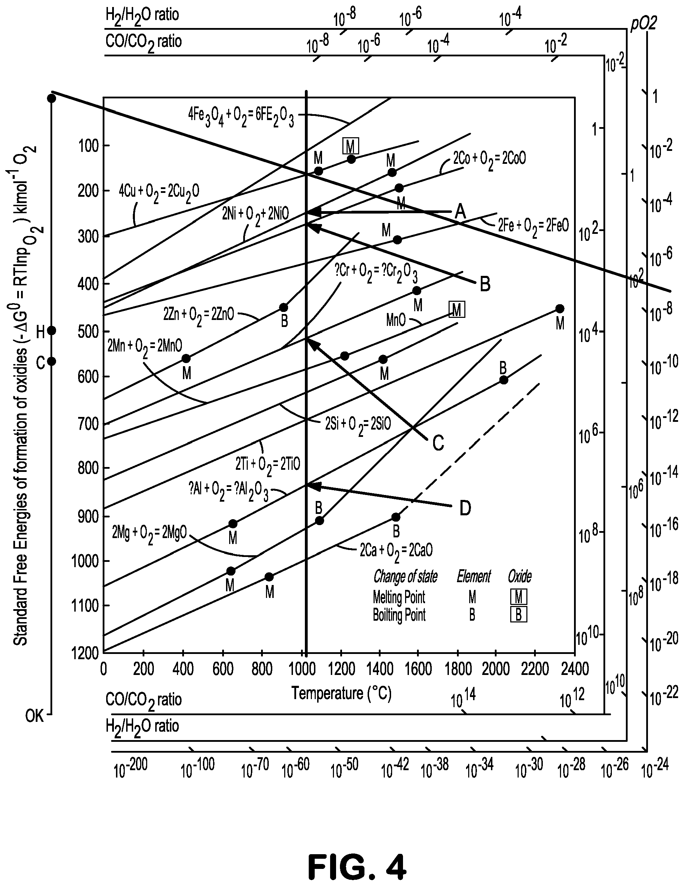

Referring now to Fig. 4, there is shown a typical oxygen preheat environment at 1832 degrees Fahrenheit (1000 degrees Centigrade) and a pressure of 0.0133Nm⁻² (10⁻⁴ Torr). The diagram shows equilibrium promoting the oxidation of nickel (A), cobalt (B), chrome (C), and aluminum (D) which are the main components of a NiCoCrAlY bond coat. To use the Ellingham Diagram, one connects a line between the appropriate reference point and the associated environmental condition. All of the metal-metal oxide reactions that fall below the intersection are favored.

Referring now to Fig. 5, there is shown a carbon monoxide/carbon dioxide preheat environment at 1832 degrees Fahrenheit (1000 degrees Centigrade) at a pressure of 0.0133 Nm⁻² (10⁻⁴ Torr). The figure shows equilibrium at a carbon monoxide/carbon dioxide ratio of greater than 10⁴ (or >10,000). Only a very small percent of carbon dioxide is required to promote alpha alumina formation reaction (D) in the bond coat. To accelerate the kinetics of this reaction, slightly higher ratios may be required. As can be seen from the diagram, only the formation of alumina is favored.

Carbon dioxide, backfilled into the preheat chamber prior to heat-up, displaces the air and provides a more protective atmosphere to minimize the growth of undesirable metastable oxides. The heating elements will react with the carbon dioxide, converting it to carbon monoxide. The carbon monoxide/carbon dioxide ratio will climb, producing an increasingly protective atmosphere as the temperature climbs and thereby inhibit the formation of metastable oxides. A high carbon monoxide/carbon dioxide ratio can protect Ni, Cr, Co and Al from forming oxides during preheat. The conditions will not favor carburization due to the low pressure within the preheat chamber.

A low flow carbon dioxide introduced into the preheat chamber at 1832 degrees Fahrenheit (1000 degrees Centigrade) and at low pressure (10⁻⁴ Torr) will lower the carbon monoxide/carbon dioxide ratio and thereby promote the growth of alpha alumina thermally grown oxide. Therefore, the thermally grown oxide control will be a factor of carbon dioxide flow. Control of the carbon dioxide flow will provide the oxidizer necessary for alpha alumina formation in the preheat chamber. As in preheat, carbon dioxide will tend to form 100% carbon monoxide at equilibrium. However, the preheat chamber is a dynamic system, with a flow of carbon dioxide in while the chamber is being simultaneously pumped out. The kinetics of the reaction to form the carbon monoxide are not fast enough to keep up with the flow rate of carbon dioxide.

Using the preheating treatment shown in Fig. 2, one can form a thermally grown oxide layer on a surface of the bond coat layer, which thermally grown oxide layer can be an alpha alumina TGO or a complex oxide of alumina layer.

There has been provided herein a preheat chamber oxidation process. While the preheat chamber oxidation process has been described in the context of the specific embodiments described herein, other unforeseen alternatives, modifications, and variations may become apparent to those skilled in the art having read the foregoing description. Accordingly, it is intended to embrace those alternatives, modifications, and variations which fall within the scope of the appended claims.

## Claims

1. A process for coating a part comprising the steps of:
a. loading at least one bond coated part into a load chamber;
b. moving the at least one bond coated part from the load chamber to a preheat chamber;
c. backfilling said preheat chamber with a protective atmosphere of carbon dioxide;
d. reducing the pressure in the preheat chamber to in the range of 1.33Nm⁻² and 0.00133Nm⁻² ;
e. heating said at least one bond coated part within said preheat chamber to a temperature in the range of 982°C - 1093°C;
f. flowing carbon dioxide into the preheat chamber at a flow rate in the range of 50sccm - 500sccm while maintaining a pressure in the range of 1.33Nm⁻² - 0.00133Nm⁻² causing a thermally grown oxide layer to form;
g. moving said at least one bond coated part with said thermally grown oxide layer to a coating chamber;
wherein the flowing step occurs after the temperature of said at least one bond coated part has reached 1000°C; and wherein, during the heating step, the protective atmosphere becomes an equilibrium mixture of carbon monoxide/carbon dioxide of a ratio of greater than 10,000; and
wherein said thermally grown oxide layer comprises an alpha alumina thermally grown oxide layer and wherein said bond coated part comprises a bond coat comprising MCrAlY;
wherein MCrAlY is NiCrAlY or CoCrAlY.

2. The process of claim 1, further comprising forming a coating over said thermally grown oxide layer.

## Patentansprüche

1. Verfahren zum Überziehen eines Teils, die folgenden Schritte umfassend:
a. Laden von zumindest einem mit Bindeüberzug versehenen Teil in eine Ladekammer;
b. Bewegen des zumindest einen mit Bindeüberzug versehenen Teils aus der Ladekammer zu einer Vorheizkammer;
c. Rückfüllen der Vorheizkammer mit einer Schutzatmosphäre aus Kohlenstoffdioxid;
d. Reduzieren des Drucks in der Vorheizkammer auf 1,33 Nm⁻² bis 0,00133 Nm⁻²;
e. Erwärmen des zumindest einen mit Bindeüberzug versehenen Teils innerhalb der Vorheizkammer auf eine Temperatur von 982 °C-1093 °C;
f. Strömen von Kohlenstoffdioxid in die Vorheizkammer bei einer Strömungsrate von 50 sccm-500 sccm, während ein Druck bei 1,33 Nm⁻²-0,00133 Nm⁻² gehalten wird, wodurch bewirkt wird, dass sich eine thermisch gewachsene Oxidschicht bildet;
g. Bewegen des zumindest einen mit Bindeüberzug versehenen Teils mit der thermisch gewachsenen Oxidschicht zu einer Beschichtungskammer;
wobei der Strömungsschritt stattfindet, nachdem die Temperatur des zumindest einen mit Bindeüberzug versehenen Teils 1000 °C erreicht hat; und
wobei, während des Erwärmungsschrittes, die Schutzatmosphäre zu einem Gleichgewichtsgemisch aus Kohlenstoffmonoxid/Kohlenstoffdioxid mit einem Verhältnis von mehr als 10.000 wird; und
wobei die thermisch gewachsene Oxidschicht eine thermisch gewachsene Alpha-Aluminiumoxid-Oxidschicht umfasst und wobei das mit Bindeüberzug versehene Teil einen Bindeüberzug umfasst, der MCrAlY umfasst;
wobei MCrAlY NiCrAlY oder CoCrAlY ist.

2. Verfahren nach Anspruch 1, ferner umfassend das Bilden eines Überzugs über der thermisch gewachsenen Oxidschicht.

## Revendications

1. Procédé de recouvrement d'une pièce comprenant les étapes de :
a. chargement d'au moins une pièce avec une couche de liaison dans une chambre de chargement ;
b. déplacement de l'au moins une pièce avec une couche de liaison de la chambre de chargement à une chambre de préchauffage ;
c. remplissage de ladite chambre de préchauffage avec une atmosphère de protection de dioxyde de carbone ;
d. réduction de la pression dans la chambre de préchauffage dans la plage allant de 1,33Nm⁻² à 0,00133Nm⁻² ;
e. chauffage de ladite au moins une pièce avec une couche de liaison à l'intérieur de ladite chambre de préchauffage à une température dans la plage allant de 982 °C à 1 093 °C ;
f. mise en circulation du dioxyde de carbone dans la chambre de préchauffage à un débit dans la plage allant de 50 sccm à 500 sccm tout en maintenant une pression dans la plage allant de 1,33Nm⁻² à 0,00133Nm⁻² entraînant la formation d'une couche d'oxyde à croissance thermique ;
g. déplacement de ladite au moins une pièce avec une couche de liaison avec ladite couche d'oxyde à croissance thermique vers une chambre de recouvrement ;
dans lequel l'étape de mise en circulation a lieu après que la température de ladite au moins une pièce avec une couche de liaison a atteint 1 000 °C ; et
dans lequel, pendant l'étape de chauffage, l'atmosphère de protection devient un mélange d'équilibre de monoxyde de carbone/dioxyde de carbone selon un rapport supérieur à 10 000 ; et
dans lequel ladite couche d'oxyde à croissance thermique comprend une couche d'oxyde à croissance thermique d'alpha alumine et dans lequel ladite pièce avec une couche de liaison comprend une couche de liaison comprenant MCrAlY ;
dans lequel MCrAlY est NiCrAlY ou CoCrAlY.

2. Procédé selon la revendication 1, comprenant en outre la formation d'un revêtement sur ladite couche d'oxyde à croissance thermique.
